(19) Europäisches Patentamt
European Patent Office
Office européen des brevets

(11) **EP 1 153 425 B1**

(12) **EUROPÄISCHE PATENTSCHRIFT**

(45) Veröffentlichungstag und Bekanntmachung des Hinweises auf die Patenterteilung:
**01.06.2011 Patentblatt 2011/22**

(21) Anmeldenummer: **00972618.3**

(22) Anmeldetag: **10.10.2000**

(51) Int Cl.:
**H01L 21/3065** *(2006.01)* **H01J 37/32** *(2006.01)*

(86) Internationale Anmeldenummer:
**PCT/DE2000/003545**

(87) Internationale Veröffentlichungsnummer:
**WO 2001/039261 (31.05.2001 Gazette 2001/22)**

(54) **PLASMAÄTZVERFAHREN MIT GEPULSTER SUBSTRATELEKTRODENLEISTUNG**

METHOD FOR PLASMA ETCHING WITH PULSED SUBSTRATE ELECTRODE POWER

PROCEDE DE GRAVURE AU PLASMA A PUISSANCE D'ELECTRODES DE SUBSTRAT PULSEE

(84) Benannte Vertragsstaaten:
**CH DE FR GB LI NL**

(30) Priorität: **27.11.1999 DE 19957169**

(43) Veröffentlichungstag der Anmeldung:
**14.11.2001 Patentblatt 2001/46**

(73) Patentinhaber: **ROBERT BOSCH GMBH**
**70442 Stuttgart (DE)**

(72) Erfinder:
• **LAERMER, Franz**
**71263 Weil der Stadt (DE)**
• **SCHILP, Andrea**
**73525 Schwaebisch Gmuend (DE)**

(56) Entgegenhaltungen:
• **PATENT ABSTRACTS OF JAPAN vol. 1998, no. 01, 30. Januar 1998 (1998-01-30) -& JP 09 232738 A (NISSIN ELECTRIC CO LTD), 5. September 1997 (1997-09-05)**
• **PATENT ABSTRACTS OF JAPAN vol. 1995, no. 03, 28. April 1995 (1995-04-28) -& JP 06 342770 A (NISSIN ELECTRIC CO LTD), 13. Dezember 1994 (1994-12-13)**
• **PATENT ABSTRACTS OF JAPAN vol. 1998, no. 08, 30. Juni 1998 (1998-06-30) -& JP 10 074730 A (HITACHI LTD), 17. März 1998 (1998-03-17)**

**Beschreibung**

Die Erfindung betrifft ein Verfahren zum Ätzen von Strukturen in einem Ätzkörper mittels eines Plasmas, nach der Gattung des Hauptanspruches.

Stand der Technik

Anisotrope Plasmaätzverfahren sind beispielsweise aus DE 197 06 682 A1 oder DE 42 41 045 C2 bekannt, in denen jeweils über eine hochdichte Plasmaquelle ein Plasma aus neutralen Radikalen und elektrisch geladenen Teilchen erzeugt wird, die durch eine Biasspannungsquelle zu einer Substratelektrode, die den zu prozessierenden Wafer trägt, hin beschleunigt werden. Durch die Vorzugsrichtung der einfallenden Ionen kommt dabei ein gerichteter Ätzprozeß zustande.

Als Biasspannungsquelle, die die elektrische Spannung zur Beschleunigung der Ionen aus dem Plasma zur Substratelektrode erzeugt, werden weiter üblicherweise Hochfrequenzgeneratoren mit einer Träger-Frequenz von 13,56 MHz verwendet. Dabei wird der Hochfrequenzgenerator jeweils durch ein LC-Netzwerk ("Matchbox") an die Impedanz der Substratelektrode und des Plasmas, das in Kontakt mit der Substratelektrode steht, angepaßt.

Mit Rücksicht auf eine gute Maskenselektivität, das ist das Verhältnis der Siliziumätzrate zur Ätzgeschwindigkeit der Maskierschicht, ist weiter bereits bekannt, die Hochfrequenzleistung an der Substratelektrode relativ niedrig zu wählen, um den ionenunterstützten Maskenabtrag möglichst gering zu halten. Übliche Leistungswerte liegen zwischen 5 Watt und 20 Watt, so daß die Energie der auf die Substratoberfläche einfallenden Ionen typischerweise einige 10 eV beträgt.

Derart niedrige Ionenenergien sind zwar hinsichtlich der Maskenselektivität vorteilhaft, sie führen jedoch auch dazu, daß die einfallenden Ionen in ihrer Richtung relativ stark streuen und teilweise vom gewünschten senkrechten Einfall abweichen oder leicht abgelenkt werden können, d.h. ihre Direktionalität ist gering. Derartige Abweichungen der Direktionalität der einfallenden Ionen korrelieren dann mit einer erschwerten Profilkontrolle der erzeugten Ätzprofile. Unter dem Aspekt der Direktionalität des Ionenstroms wäre daher eine hohe Ionenbeschleunigung, also hohe Ionenenergie, wünschenswert, was aber mit der geforderten Maskenselektivität kollidiert.

Weiter kommt es beim Einsatz hochdichter Plasmen mit niederenergetischer Ioneneinwirkung auf einem Substrat beim Auftreffen auf einen Ätzstop aus Dielektrika (vergrabene Oxide, Lackschichten, usw.) vielfach zu Aufladungseffekten an der Grenzschicht Silizium-Dielektrikum. Daraus resultierende Profilstörungen in Silizium bezeichnet man als Taschenbildung ("Notching") am dielektrischen Interface.

Gleichzeitig wächst mit abnehmender Ionenenergie auch die Gefahr der sogenannten "Grasbildung" auf dem Ätzgrund, d.h. das Prozeßfenster für einen sicheren Ätzprozeß ohne Grasbildung ist limitiert. Unter "Grasbildung" versteht man dabei eine ungleichmäßige Ätzung des Ätzgrundes unter Ausbildung von einer Vielzahl von eng benachbarten Spitzen, die die Form eines Rasens annehmen.

In den Anmeldungen DE 199 33 842.6 und DE 199 19 832.2 wurde zur Lösung dieser Probleme bereits vorgeschlagen, die hochfrequente Wechselspannung, die zur Substratbiaserzeugung, d.h. zur Erzeugung der in das zu ätzende Substrat einzukoppelnden Substratelektrodenleistung, verwendet wird, zu pulsen, und gleichzeitig die Ionenenergie während der Hochfrequenzimpulse höher zu wählen als bei einem Dauerstrichbetrieb.

Bei diesem Pulsbetrieb wird jedoch beobachtet, daß eine wirksame Unterdrückung der Taschenbildung erst bei relativ langen Pausenzeiten von 0,1 ms bis 1 ms zwischen den angelegten Hochfrequenzimpulsen erreicht wird. Werden die Impulspausen unter 0,1 ms verkürzt, tritt in zunehmendem Maße erneut Taschenbildung auf, die auch durch eine Steigerung der Impulsspitzenleistung und eine korrespondierende Verkürzung der Impulsdauer nicht mehr unterdrückt werden kann.

Für lange Pausenzeiten von 0,1 ms bis 1 ms verengt sich überdies das Prozeßfenster für einen sicheren Prozeß, d.h. einen grasfreien Ätzgrund, bei Verkürzung der Pulszeit mit entsprechender Steigerung der Impulsspitzenleistung, d.h. der Ätzprozeß wird zwar immer taschenstabiler, die Unterdrückung eines grasfreien Ätzgrundes wird jedoch immer geringer. Die Forderung eines "taschenstabilen" Prozesses steht somit bisher im Widerspruch zu einem "grasstabilen" Prozeß.

Unter dem Prozeßfenster versteht man dabei die für die Durchführung eines in der erläuterten Weise sicheren Ätzprozesses geeigneten Prozeßparameterbereiche, insbesondere hinsichtlich Prozeßdruck, Substratelektrodenleistung, Plasmaleistung und Gasflüsse sowie gegebenenfalls der Taktzeiten für alternierende Ätz- und Passivierzyklen.

Insgesamt sind bei den bekannten Verfahren somit unter den Randbedingungen einer ausreichenden Unterdrückung der "Taschenbildung" und eines "grasfreien" Ätzgrundes die einsetzbaren Hochfrequenzimpulsspitzenleistungen und damit die Ionenenergien, also die Direktionalität des Ioneneinfalls, begrenzt, so daß bisher eine unerwünschte Einengung des Prozeßfensters, d.h. der verwendbaren Prozeßparameter, eintritt.

Besonders störend wirkt sich diese Einengung des Prozeßfensters aufgrund der Grasbildung dann aus, wenn Hochratenätzprozesse durchgeführt werden sollen, da damit der Bereich der zulässigen Prozeßdrücke nach oben begrenzt ist. Andererseits sind gerade hohe Drücke, hohe Gasflüsse und hohe Plasmaleistungen an der induktiven Quelle vorteilhaft zur Erreichung hoher Ätzraten. JP09232738 offenbart ein gepulstes Plasmaätzverfahren zum Reinigen von Metalloxiden auf Boudpads. JP06342770 offenbart ein gepulstes Plasmaätzverfahrenzum Ätzen von Öffenugen in Silizium mit Puls-zu-Pause Verhältuissen größer 1:2.

Vorteil der Erfindung

Das erfindungsgemäße Plasmaätzverfahren gemäß Anspruch 1 hat gegenüber dem Stand der Technik den Vorteil, daß damit die Puls- und Pausenzeiten der eingekoppelten, hochfrequent gepulsten Hochfrequenzleistung deutlich verkürzt werden können, und damit ein Pulsbetrieb mit hoher Repetitionsrate im 100 kHz-Bereich darstellbar ist.

Entsprechend dem Puls-zu-Pause-Verhältnis kann bei dieser hohen Wiederholfrequenz weiter vorteilhaft nunmehr auch die Impulsspitzenleistung umgekehrt proportional dazu erhöht bzw. hochskaliert werden.

Gleichzeitig wird neben der effektiven Unterdrückung der Taschenbildung (Notching-Effekte) ein sehr stabiler und robuster Prozeß erreicht, der bei Variation der Prozeßparameter innerhalb eines weiten Prozeßfensters nicht zur Bildung von "Gras" am Ätzgrund neigt.

Weiter können bei dem erfindungsgemäßen Verfahren nunmehr sehr hohe Hochfrequenzspitzenleistungen bei entsprechend kurzer Pulsdauer, d.h. entsprechend kleinem Puls-zu-Pause- bzw. Impuls-zu-Periode-Verhältnis, eingesetzt werden. Damit ergibt sich vorteilhaft eine entsprechend hohe Ionenenergie von typischerweise 50 eV bis 1000 eV, was mit einer sehr guten Direktionalität des Ioneneinfalls verbunden ist.

Dabei nutzt man aus, daß beim Einsatz kurzer Pulse mit hoher Wiederholrate die zeitliche Mittelung der Leistungswerte über eine dichte Folge von Kurzzeitpulsen erfolgt, von denen jeder einzelne nur einen relativ geringen Energieeintrag auf den Ätzkörper darstellt. Dies führt insgesamt zu einer hohen Prozeßstabilität.

Im Gegensatz zu relativ langen Pulsen mit relativ langen Pausen, bei denen die Energie in einem Einzelimpuls bereits so groß ist, daß während eines Einzelimpulses Störeffekte in der Elektroden-Plasma-Wechselwirkung auftreten, wird bei dem erfindungsgemäßen Verfahren vorteilhaft weiter nicht mehr beobachtet, daß bei Verkürzung der Pulsdauern und entsprechender Erhöhung der Impulsspitzenleistung eine Erhöhung der bei der Ätzung benötigten mittleren eingetragenen Leistung in die Substratelektrode bzw. den Ätzkörper erforderlich ist. Vielmehr skalieren nun Puls-zu-Periode-Verhältnis und benötigte Impulsspitzenleistung recht gut umgekehrt proportional.

Insgesamt werden durch die hochfrequente Pulsung der Hochfrequenzleistungspulse Störeffekte in der Plasma-Substratelektrodenwechselwirkung wirksam unterdrückt, so daß bei gegebener Frequenz des Hochfrequenzgenerators, beispielsweise 13,56 MHz, und gegebener, mittlerer, in den Ätzkörper eingekoppelter Hochfrequenzleistung die Ionenenergie und entsprechend der mittlere Ionenstrom auf den Ätzkörper frei gewählt werden kann.

Wenn man mit P die mittlere, in den Ätzkörper eingekoppelte Hochfrequenzleistung, die für einen bestimmten Ätzprozeß konstant gehalten werden soll, mit p die Pulsspitzenleistung bzw. Amplitude der Hochfrequenzleistung in einem Puls, mit d das Puls-zu-Periode-Verhältnis ("Duty Cycle"), mit u die Ionenbeschleunigungsspannung entsprechend der Energie der auf den Ätzkörper auftreffenden Ionen, mit i den gepulsten Ionenstrom, und mit I den zeitlichen Mittelwert des Ionenstroms bezeichnet, gilt daher bei dem erfindungsgemäßen Prozeß nunmehr:

$$p = \frac{P}{d}$$

$$u = \sqrt{X\frac{P}{d}} \propto \sqrt{\frac{1}{d}}$$

$$i = \sqrt{\frac{1}{X}\frac{P}{d}}$$

$$I = \sqrt{\frac{1}{X}Pd} \propto \sqrt{d}$$

Dabei wurde angenommen, daß sich die Plasmaimpedanz X mit der eingekoppelten Hochfrequenzleistung nur wenig ändert, also das Ohm'sche Gesetz näherungsweise zutrifft. In der Praxis wird sich die Plasmaimpedanz X mit Erhöhung der eingekoppelten Hochfrequenzleistung aufgrund von Sättigungseffekten des Ionenstroms und begrenzter, verfügbarer Ionendichten im Plasma sogar noch erhöhen und somit den beschriebenen Effekt noch verstärken.

Insgesamt führt das erfindungsgemäße Verfahren somit vorteilhaft dazu, daß sich bei verkleinertem Puls-zu-Periode-Verhältnis d (oder analog einem verkleinerten Puls-zu-Pause-Verhältnis) und entsprechend hochskalierter Impulsspitzenleistung p, d.h. konstanter mittlerer Leistung P, für die Energie u der auf den Wafer auftreffenden Ionen gilt: $u \propto \sqrt{\frac{1}{d}}$ , während der mittlere Strom I sich gemäß $I \propto \sqrt{d}$ verhält.

Somit kann nunmehr über den "Duty Cycle-Parameter" d bei gleichem Leistungseintrag frei gewählt werden, ob eine hohe Ionenenergie mit entsprechend geringem mittleren Ionenstrom oder eine niedrige Ionenenergie mit entsprechend hohem mittleren Ionenstrom eingestellt werden soll. Man hat also einen zusätzlichen Freiheitsgrad des erfindungsgemäßen Ätzprozesses erhalten, der in seiner Wirkung einer Einstellbarkeit der Plasmaimpedanz entspricht, und der dazu genutzt werden kann, das Prozeßfenster, beispielsweise für Hochratenätzprozesse, zu erweitern.

Das erfindungsgemäße Verfahren hat weiter den wesentlichen Vorteil, daß neben einer hochfrequent gepulsten Hochfrequenzleistung, die der Prozeßstabilität in einem weiten Prozeßfenster und der Unterdrückung von über die Kenngrößen Ionenenergie und mittlerer Ionenstrom steuerbaren Grasbildung dient, und die auch zu hohen Ätzraten führt, mittels der zusätzlichen, niederfrequenten Modulation der hochfrequent gepulsten Hochfrequenzleistung auch die Taschenbildung an dielektrischen Grenzflächen wirksam unterdrückt werden kann.

Diese niederfrequente Modulation beruht auf der Erkenntnis, daß zu einem Abbau von Aufladungseffekten an diesen dielektrischen Grenzflächen relativ lange Zeiten von in der Regel mehr als 0,5 ms erforderlich sind. Daraus resultiert ein Frequenzbereich für die niederfrequente Modulation von 10 Hz bis 10000 Hz, vorzugsweise von 50 Hz bis 1000 Hz.

Das erfindungsgemäße Verfahren eignet sich somit besonders vorteilhaft für einen taschenstabilen Hochratenätzprozeß bei erhöhtem Prozeßdruck von beispielsweise 20 μbar bis 300 μbar und hoher Plasmaleistung von bis zu 5000 Watt.

Vorteilhafte Weiterbildungen der Erfindung ergeben sich aus den in den Unteransprüchen genannten Maßnahmen.

So ist besonders vorteilhaft, daß auch bei einem kleinen Puls-zu-Pause-Verhältnis von beispielsweise 1:9 bis 1:19 und entsprechend hohen Pulsspitzenleistungen der eingekoppelten Hochfrequenzleistungspulse von 100 Watt bis 200 Watt ein breites Prozeßfenster hinsichtlich der Grasbildungsgefahr erhalten bleibt.

Weiter ist vorteilhaft, daß übliche Hochfrequenzgeneratoren so betrieben werden können, daß eine hochfrequente Pulsung der eingekoppelten Hochfrequenzleistung in Form von Rechteckpulsen möglich ist, wobei die Anstiegszeiten der Taktflanken bei einer Trägerfrequenz von 13,56 MHz weniger als 0,3 μs aufweisen. Damit kann das erfindungsgemäße Verfahren vorteilhaft mit kommerziell erhältlichen Generatoren durchgeführt werden, die gegebenenfalls lediglich geringfügig modifiziert werden müssen.

Eine derartig kurze Anstiegszeit der Taktflanken ist erforderlich, um überhaupt eine hochfrequente Leistungspulsung mit einer Frequenz von 10 kHz bis 500 kHz durchführen zu können.

Für die Impulsspitzenleistung, d.h. die Amplitude der Hochfrequenzleistung während eines eingekoppelten Hochfrequenzleistungspulses können weiter vorteilhaft Leistungen von 30 Watt bis zu 1200 Watt eingesetzt werden.

Zur Erzeugung der niederfrequenten Modulation der hochfrequent gepulsten Hochfrequenzleistung stehen weiter vorteilhaft zwei alternative, jeweils einfach zu realisierende Möglichkeiten zur Verfügung.

Einerseits kann der in der Generatoreinheit integrierte, bereits hochfrequent getaktete Hochfrequenzgenerator, beispielsweise über dessen Gate-Eingang, zusätzlich direkt mit einer niederfrequenten Taktung ein- und ausgeschaltet werden.

Andererseits besteht auch die Möglichkeit, einen in die Generatoreinheit integrierten hochfrequenten Taktgeber, der das eigentliche Trägersignal des Hochfrequenzgenerators moduliert, und damit die hochfrequente Pulsung der Hochfrequenzleistung bewirkt, mit einem niederfrequenten Taktgeber zu steuern. Auf diese Weise wird der hochfrequente Taktgeber niederfrequent ein- und ausgetastet, was sich entsprechend auch auf die eingekoppelten Hochfrequenzleistungspulse überträgt.

Zeichnungen

Die Erfindung wird anhand der Zeichnungen und in der nachfolgenden Beschreibung näher erläutert. Die Figuren 1a bis 1c erläutern das Pulsen der in den Ätzkörper eingekoppelten Hochfrequenzleistung, die Figur 2 zeigt eine Prinzipskizze einer Ätzanlage zur Durchführung des Ätzverfahrens, und die Figuren 3a und 3b erläutern zwei alternative Ausführungsformen der Generatoreinheit.

Ausführungsbeispiele

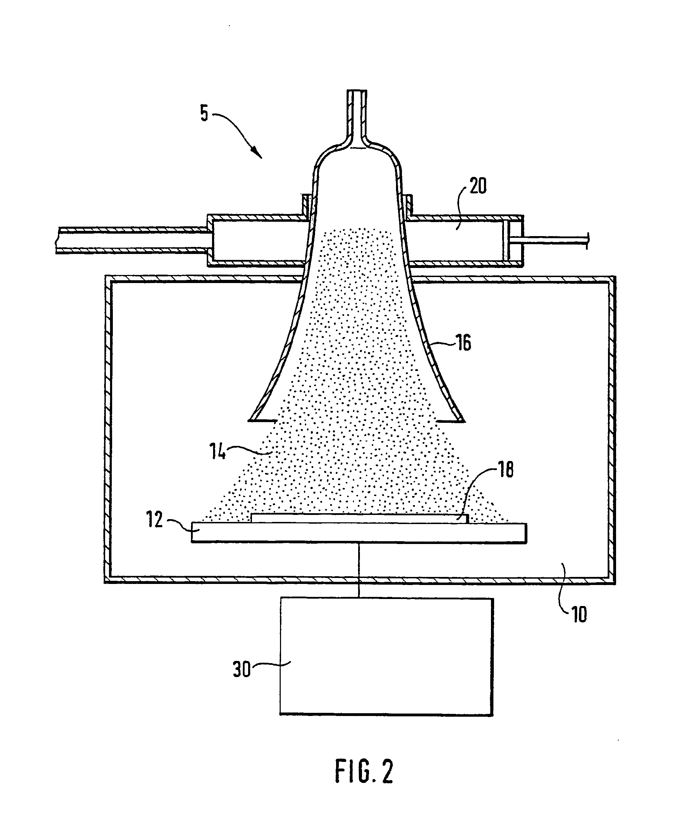

Die Figur 2 zeigt eine prinzipiell aus DE 42 41 045 C2 oder DE 197 06 682 A1 bekannte Plasmaätzanlage 5 zur Durchführung eines anisotropen Plasmaätzverfahrens. Dazu ist in einer Ätzkammer 10 eine Substratelektrode 12 mit einem darauf angeordneten Ätzkörper 18 vorgesehen, der im erläuterten Beispiel ein Siliziumwafer ist. Weiter steht die Substratelektrode 12 mit einer Generatoreinheit 30 elektrisch in Verbindung. Außerdem ist ein Resonator 20 vorgesehen, mit dem in der Ätzkammer 10 im Bereich eines Surfatrons 16 ein Plasma 14 erzeugt wird. Das erläuterte Ausführungsbeispiel ist jedoch nicht auf eine derartige Anlagenkonfiguration beschränkt. Insbesondere eignet sich dazu auch eine an sich bekannte ICP-Plasmaquelle ("Inductively Coupled Plasma") oder ECR-Plasmaquelle ("Electron Cyclotron Resonance").

Wesentlich ist stets nur, daß eine hochdichte Plasmaquelle ein Plasma 14 erzeugt, das aus neutralen Radikalen und elektrisch geladenen Teilchen (Ionen) besteht, wobei die Ionen durch eine in die Substratelektrode 12 bzw. darüber in den Ätzkörper 18 eingekoppelte Hochfrequenzleistung zu der Substratelektrode 12 hin beschleunigt werden, die den zu prozessierenden Ätzkörper 18 trägt, und dort annähernd senkrecht auftreffen, so daß durch die Vorzugsrichtung der einfallenden Ionen ein gerichteter Ätzprozeß zustande kommt.

Auf weitere Details der mit Ausnahme der erfindungsgemäßen Ausführung der Generatoreinheit 30 an sich bekannten Ätzanlage 5 wird verzichtet, da diese dem Fachmann bekannt sind.

Die Generatoreinheit 30 weist einen kommerziell erhältlichen Hochfrequenzgenerator 33, einen Hochfrequenztaktgeber 32, einen Niederfrequenztaktgeber 31 und eine sogenannte "Matchbox" 34, d.h. ein LC-Netzwerk, auf.

Die Matchbox 34 dient dabei in bekannter Weise dazu, den Hochfrequenzgenerator 33 an die Impedanz der Substratelektrode 12 und des Plasmas 14, das in Kontakt mit der Substratelektrode 12 steht, anzupassen.

Um eine gute Maskenselektivität (Verhältnis der Ätzrate des Ätzkörpers 18 zu der Ätzgeschwindigkeit einer darauf aufgebrachten Maskierschicht) zu gewährleisten, wird über die Generatoreinheit 30 im zeitlichen Mittel eine Hochfrequenzleistung von 1 Watt bis 30 Watt in die Substratelektrode 12 eingekoppelt.

Um die in die Substratelektrode 12 und darüber in den Ätzkörper 18 eingekoppelte, hochfrequent gepulste Hochfrequenzleistung zu erzeugen, ist zunächst vorgesehen, daß der Hochfrequenzgenerator 33 in der Generatoreinheit 30 ein hochfrequentes Trägersignal 54 mit einer Frequenz von bevorzugt 13,56 MHz und einer Leistung von beispielsweise 400 Watt erzeugt. Anstelle der Frequenz des Trägersignals von 13,56 MHz kommen jedoch ebenso Frequenzen von 1 MHz bis 50 MHz in Frage. Die Leistung des Hochfrequenzgenerators 33 kann weiter auch zwischen 30 Watt bis 1200 Watt betragen. Bevorzugt sind Leistungen von 50 Watt bis 500 Watt.

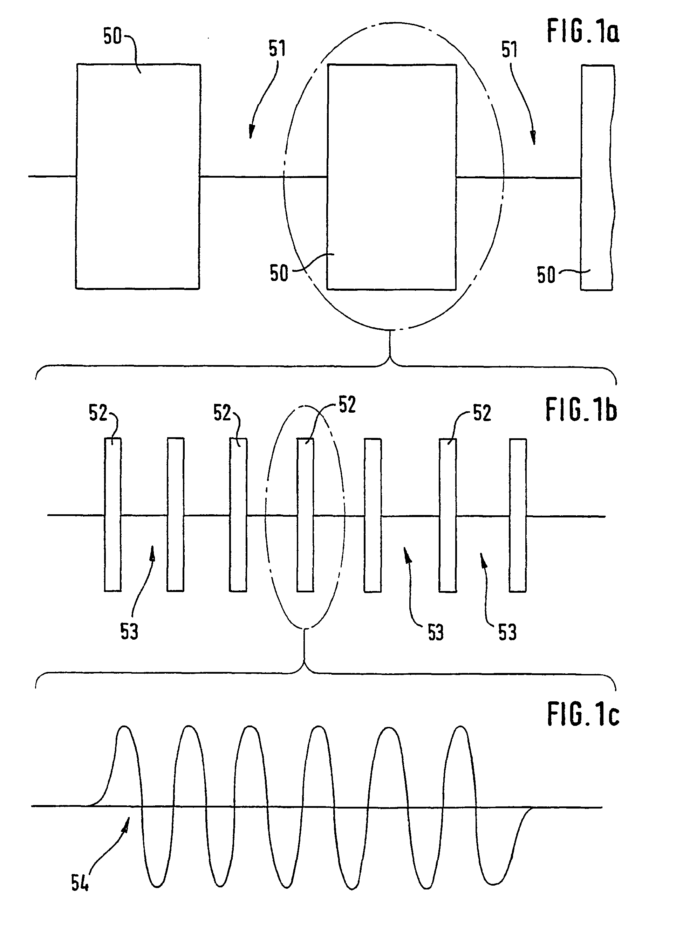

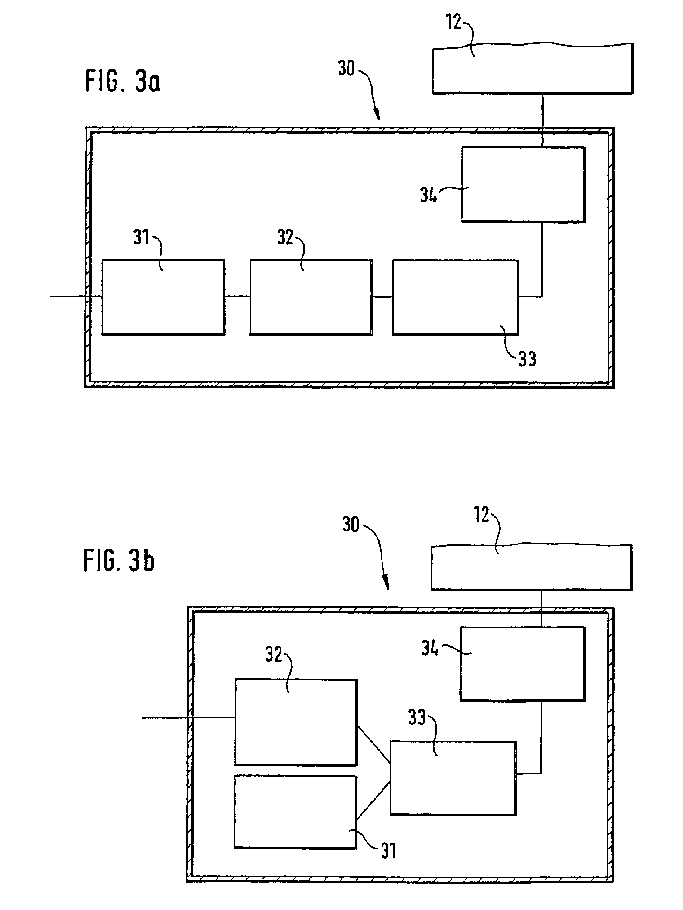

In einem ersten Ausführungsbeispiel der Erfindung ist gemäß Figur 3a weiter vorgesehen, daß die Generatoreinheit 30 neben dem Hochfrequenzgenerator 33 und der Matchbox 34 einen an sich bekannten Hochfrequenztaktgeber 32 aufweist, der den Hochfrequenzgenerator 33 derart steuert, daß dieser eine hochfrequent gepulste Hochfrequenzleistung erzeugt. Dies wird anhand der Figuren 1c und 1b erläutert.

Im einzelnen ist in Figur 1c das hochfrequente Trägersignal 54 des Hochfrequenzgenerators 33 mit einer Frequenz von beispielsweise 13,56 MHz und einer Spannungsamplitude, die einer Leistung von beispielsweise 400 Watt entspricht, dargestellt. Durch das Pulsen des Hochfrequenzgenerators 33 mit dem Hochfrequenztaktgeber 32 entstehen dann gemäß Figur 1b hochfrequente Pulse 52 auf die jeweils eine hochfrequente Pulspause 53 folgt. Die Taktung des Trägersignals 54 des Hochfrequenzgenerators 33 durch den Hochfrequenztaktgeber 32 erfolgt mit einer Frequenz von 10 kHz bis 500 kHz, bevorzugt von 50 kHz bis 200 kHz. Das Puls-zu-Pause-Verhältnis der hochfrequent gepulsten Hochfrequenzleistung gemäß Figur 1b liegt zwischen 1:1 und 1:100. Besonders bevorzugt liegt es zwischen 1:2 und 1:19.

Durch das gewählte Puls-zu-Pause-Verhältnis der hochfrequent gepulsten Hochfrequenzleistung wird zunächst, ausgehend von der erzeugten Leistung des Hochfrequenzgenerators 30, eine über Pulse und Pausen zeitlich gemittelte Hochfrequenzleistung von 1 Watt bis 100 Watt erzeugt.

Die Generatoreinheit 30 weist weiter gemäß Figur 3a einen an sich bekannten Niederfrequenztaktgeber 31 auf, der den Hochfrequenztaktgeber 32 periodisch ein- und ausschaltet bzw. taktet. Auf diese Weise wird die hochfrequent gepulste Hochfrequenzleistung gemäß Figur 1b zusätzlich niederfrequent moduliert. Im einzelnen taktet dazu der Niederfrequenztaktgeber 31 den Hochfrequenztaktgeber 32 mit einer Frequenz von 10 Hz bis 10000 Hz. Bevorzugt sind Frequenzen von 50 Hz bis 1000 Hz.

Insgesamt wird somit durch die niederfrequente Taktung bzw. niederfrequente Modulation mit Hilfe des Niederfrequenztaktgebers 31 ein periodisches Abschalten und Einschalten der eingekoppelten, gepulsten Hochfrequenzleistung in die Substratelektrode 12 und darüber in den Ätzkörper 18 bewirkt. Das Puls-zu-Pause-Verhältnis der niederfrequenten Taktung des Niederfrequenztaktgebers 31 gemäß Figur 1a, d.h. das Verhältnis von niederfrequenten Pulsen 50 und niederfrequenten Pulspausen 51, liegt dabei zwischen 4:1 und 1:4. Als besonders vorteilhaft hat sich herausgestellt, wenn das Puls-zu-Pause-Verhältnis der niederfrequenten Taktung zwischen 1:2 und 2:1, beispielsweise bei 1:1 liegt.

Durch die niederfrequente Taktung der hochfrequent gepulsten Hochfrequenzleistung gemäß Figur 1b wird die in den Ätzkörper 18 letztendlich eingekoppelte Hochfrequenzleistung entsprechend dem jeweiligen Puls-zu-Pause-Verhältnis (Figur 1a) reduziert, so daß schließlich in den Ätzkörper 18 eine typische Hochfrequenzleistung zwischen 1 Watt und 30 Watt eingekoppelt wird.

Die hochfrequenten Pulse 52 gemäß Figur 1b haben im übrigen hinsichtlich der Einhüllenden bevorzugt zumindest näherungsweise die Form von Rechteckpulsen, wobei die Anstiegszeit der Taktflanken der Rechteckpulse weniger als 0,3 $\mu$s beträgt.

Im übrigen ist es ohne weiteres möglich, den Niederfrequenzgeber 31 mit einer nicht dargestellten Anlagensteuerung zu verbinden, und darüber im Laufe des durchgeführten Ätzprozesses die mittlere, in den Ätzkörper 18 eingekoppelte Hochfrequenzleistung zu steuern. Dazu bietet sich besonders das Puls-zu-Pause-Verhältnis der niederfrequenten Taktung an. Das Puls-zu-Pause-Verhältnis der hochfrequent gepulsten Hochfrequenzleistung gemäß Figur 1b eignet sich besonders zur Prozeßoptimierung hinsichtlich der bereits erläuterten Grasbildung. Genauso ist es natürlich möglich, das Puls-zu-Pause-Verhältnis der niederfrequenten Taktung festzuhalten, und zur Steuerung der mittleren Leistung die Impulsspitzenleistung des Generators zu regeln.

Die Figur 3b erläutert eine zu Figur 3a alternative Ausführungsform der Generatoreinheit 30 zur Erzeugung einer hochfrequent gepulsten Hochfrequenzleistung, die niederfrequent moduliert ist. Dazu wird gemäß Figur 3b der Hochfrequenzgenerator 33 zunächst analog der Figur 3a mittels eines Hochfrequenztaktgebers 32 hochfrequent getaktet, so daß er eine hochfrequent gepulste Hochfrequenzleistung gemäß Figur 1b erzeugt. Im Unterschied zu Figur 3a ist in Figur 3b jedoch vorgesehen, daß der Niederfrequenztaktgeber 31 nicht den Hochfrequenztaktgeber 32 steuert, sondern direkt mit dem Hochfrequenzgenerator 33 verbunden ist, und diesen zusätzlich direkt taktet. Eine Schaltung gemäß Figur 3b läßt sich besonders einfach dadurch realisieren, daß man den Niederfrequenztaktgeber 31 an den Gate-Eingang üblicher Hochfrequenzgeneratoren 33 anschließt, die zusätzlich hochfrequent getaktet sind, beispielsweise über einen internen Taktgeber oder den externen Taktgeber 32. Die übrigen Verfahrensparameter bei der Durchführung des Ätzverfahrens gemäß Figur 3b entsprechend dem Verfahren gemäß Figur 3a bzw. den Figuren 1a bis 1c.

Die Figuren 1a bis 1c erläutern zusammenfassend in der Übersicht noch einmal die in den Ätzkörper 18 eingekoppelte, mit einer niederfrequenten Modulation versehene, hochfrequent gepulste Hochfrequenzleistung. Dazu geht man zunächst von Figur 1c, d.h. dem hochfrequenten Trägersignal 54 des Hochfrequenzgenerators 33 aus. Dieses Trägersignal 54 wird durch den Hochfrequenztaktgeber 32 gemäß Figur 1b in hochfrequente Pulse 52 und hochfrequente Pulspausen 53 unterteilt. Die hochfrequenten Pulse 52 haben dabei idealerweise zumindest näherungsweise die Form von Rechteckpulsen (Einhüllende) und werden durch das Trägersignal 54 gebildet. Die Figur 1a erläutert dann wie mit Hilfe des Niederfrequenztaktgebers 31 eine niederfrequente Taktung bzw. Modulation der in den Ätzkörper 18 eingekoppelten, hochfrequent gepulsten Hochfrequenzleistung vorgenommen wird. Dazu werden eine Vielzahl von hochfrequenten Pulsen 52 bzw. hochfrequenten Pulspausen 53 zu niederfrequenten Pulsen 50 zusammengefaßt, denen dann jeweils eine niederfrequente Pulspause 51 folgt. Die niederfrequenten Pulse 50 weisen als Einhüllende bevorzugt ebenfalls eine Rechteckpulsform auf. Das Signal gemäß Figur 1a wird dann über die Substratelektrode 12 in den Ätzkörper 18 als Hochfrequenzleistung eingekoppelt.

## Patentansprüche

1. Verfahren zum Ätzen von mit einer Ätzmaske lateral exakt definierten Ausnehmungen in einem Siliziumkörper, mittels eines Plasmas (14), wobei in den Ätzkörper (18) über eine zumindest zeitweilig anliegende hochfrequente Wechselspannung von 1 MHz bis 50 MHz (54) zumindest zeitweilig eine hochfrequent gepulste Hochfrequenzleistung mit einer Frequenz von 10 kHz bis 500 kHz eingekoppelt wird, wobei die eingekoppelte, hochfrequent gepulste Hochfrequenzleistung niederfrequent moduliert wird mit einer Frequenz von 10 Hz bis 10 kHz,
   **dadurch gekennzeichnet,**
   **dass** das Puls-zu-Pause-Verhältnis (52, 53) der hochfrequent gepulsten Hochfrequenzleistung zwischen 1:2 und 1:100 liegt.

2. Verfahren nach Anspruch 1, **dadurch gekennzeichnet, daß** die hochfrequente Wechselspannung mittels eines Hochfrequenzgenerators (33) bereitgestellt wird, der ein hochfrequentes Trägersignal (54) erzeugt.

3. Verfahren nach Anspruch 1, **dadurch gekennzeichnet, daß** die hochfrequent gepulste Hochfrequenzleistung mit einer Frequenz von 50 kHz bis 200 kHz gepulst wird.

4. Verfahren nach Anspruch 2, **dadurch gekennzeichnet, daß** das hochfrequente Trägersignal (54) eine Frequenz von 1 MHz bis 50 MHz, insbesondere 13,56 MHz, aufweist.

5. Verfahren nach mindestens einem der vorangehenden Ansprüche, **dadurch gekennzeichnet, daß** der Hochfrequenzgenerator (33) eine Hochfrequenzleistung mit einer Amplitude von 30 Watt bis 1200 Watt, insbesondere 50 Watt bis 500 Watt, erzeugt.

6. Verfahren nach mindestens einem der vorangehenden Ansprüche, **dadurch gekennzeichnet, daß** die hochfrequent gepulste Hochfrequenzleistung in Form von Rechteckpulsen (52) eingekoppelt wird.

7. Verfahren nach mindestens einem der vorangehenden Ansprüche, **dadurch gekennzeichnet, daß** die Rechteckpulse (52) eine Anstiegszeit der Taktflanken der Rechteckpulse (52) von weniger als 0,3 $\mu$s aufweisen.

8. Verfahren nach mindestens einem der vorangehenden Ansprüche, **dadurch gekennzeichnet, daß** das Puls-zu-Pause-Verhältnis (52, 53) der hochfrequent gepulsten Hochfrequenzleistung zwischen 1:2 und 1:19 liegt.

9. Verfahren nach mindestens einem der vorangehenden Ansprüche, **dadurch gekennzeichnet, daß** die Folge der hochfrequent gepulsten Leistungspulse (52) und Pulspausen (53) einer mittleren Hochfrequenzleistung von 1 Watt bis 100 Watt entspricht.

**10.** Verfahren nach mindestens einem der vorangehenden Ansprüche, **dadurch gekennzeichnet, daß** die niederfrequente Taktung (50, 51) oder die niederfrequente Modulation (50, 51) mit einer Frequenz von 50 Hz bis 1000 Hz erfolgt.

**11.** Verfahren nach mindestens einem der vorangehenden Ansprüche, **dadurch gekennzeichnet, daß** die niederfrequente Taktung (50, 51) oder die niederfrequente Modulation (50, 51) ein periodischen Abschalten und Einschalten der eingekoppelten gepulsten Hochfrequenzleistung bewirkt.

**12.** Verfahren nach mindestens einem der vorangehenden Ansprüche, **dadurch gekennzeichnet, daß** die in den Ätzkörper (18) eingekoppelte mittlere Hochfrequenzleistung zwischen 1 Watt und 30 Watt liegt.

**Claims**

**1.** Method for etching cutouts defined laterally exactly by an etching mask in a silicon body, by means of a plasma (14), wherein a high-frequency-pulsed high-frequency power having a frequency of 10 kHz to 500 kHz is coupled into the etching body (18) at least temporarily by means of a high-frequency AC voltage of 1 MHz to 50 MHz (54) present at least temporarily, wherein the high-frequency-pulsed high-frequency power coupled in is modulated at low frequency with a frequency of 10 Hz to 10 kHz, **characterized in that** the mark-to-space ratio (52, 53) of the high-frequency-pulsed high-frequency power is between 1:2 and 1:100.

**2.** Method according to Claim 1, **characterized in that** the high-frequency AC voltage is provided by means of a high-frequency generator (33) that generates a high-frequency carrier signal (54).

**3.** Method according to Claim 1, **characterized in that** the high-frequency-pulsed high-frequency power is pulsed with a frequency of 50 kHz to 200 kHz.

**4.** Method according to Claim 2, **characterized in that** the high-frequency carrier signal (54) has a frequency of 1 MHz to 50 MHz, in particular 13.56 MHz.

**5.** Method according to at least one of the preceding claims, **characterized in that** the high-frequency generator (33) generates a high-frequency power having an amplitude of 30 watts to 1200 watts, in particular 50 watts to 500 watts.

**6.** Method according to at least one of the preceding claims, **characterized in that** the high-frequency-pulsed high-frequency power is coupled in in the form of rectangular pulses (52).

**7.** Method according to at least one of the preceding claims, **characterized in that** the rectangular pulses (52) have a rise time of the clock edges of the rectangular pulses (52) of less than 0.3 $\mu$s.

**8.** Method according to at least one of the preceding claims, **characterized in that** the mark-to-space ratio (52, 53) of the high-frequency-pulsed high-frequency power is between 1:2 and 1:19.

**9.** Method according to at least one of the preceding claims, **characterized in that** the sequence of the high-frequency-pulsed power pulses (52) and pulse spaces (53) corresponds to an average high-frequency power of 1 watt to 100 watts.

**10.** Method according to at least one of the preceding claims, **characterized in that** the low-frequency clocking (50, 51) or the low-frequency modulation (50, 51) is effected with a frequency of 50 Hz to 1000 Hz.

**11.** Method according to at least one of the preceding claims, **characterized in that** the low-frequency clocking (50, 51) or the low-frequency modulation (50, 51) causes the pulsed high-frequency power coupled in to be periodically switched off and switched on.

**12.** Method according to at least one of the preceding claims, **characterized in that** the average high-frequency power coupled into the etching body (18) is between 1 watt and 30 watts.

**Revendications**

**1.** Procédé pour graver dans un corps en silicium des découpes définies avec précision dans la direction latérale à l'aide d'un masque de gravure, au moyen d'un plasma (14), dans lequel au moyen d'une tension alternative (54) à haute fréquence, de 1 MHz à 50 MHz, une puissance pulsée à haute fréquence, d'une fréquence de 10 kHz à 500 kHz, est injectée au moins une partie du temps dans le corps de gravure (18), la puissance pulsée à haute fréquence injectée étant modulée à basse fréquence à une fréquence de 10 Hz à 10 kHz, **caractérisé en ce que** le rapport (52, 53) entre les impulsions et les pauses de la puissance pulsée à haute fréquence est compris entre 1:2 et 1:100.

**2.** Procédé selon la revendication 1, **caractérisé en ce que** la tension alternative à haute fréquence est délivrée par un générateur (33) de hautes fréquences qui produit un signal porteur (54) à haute fréquence.

3. Procédé selon la revendication 1, **caractérisé en ce que** la puissance pulsée à haute fréquence est pulsée à une fréquence de 50 kHz à 200 kHz.

4. Procédé selon la revendication 2, **caractérisé en ce que** le signal porteur (54) à haute fréquence présente une fréquence comprise entre 1 MHz et 50 MHz et en particulier de 13,56 MHz.

5. Procédé selon au moins l'une des revendications précédentes, **caractérisé en ce que** le générateur (33) de hautes fréquences délivre une puissance à haute fréquence d'une amplitude de 30 Watt à 1 200 Watt et en particulier de 50 Watt à 500 Watt.

6. Procédé selon au moins l'une des revendications précédentes, **caractérisé en ce que** la puissance pulsée à haute fréquence est injectée sous la forme d'impulsions rectangulaires (52).

7. Procédé selon au moins l'une des revendications précédentes, **caractérisé en ce que** les impulsions rectangulaires (52) présentent un temps de montée des flancs de cadençage des impulsions rectangulaires (52) inférieur à 0,3 $\mu$s.

8. Procédé selon au moins l'une des revendications précédentes, **caractérisé en ce que** le rapport (52, 53) entre les impulsions et les pauses de la puissance pulsée à haute fréquence est compris entre 1:2 et 1:19.

9. Procédé selon au moins l'une des revendications précédentes, **caractérisé en ce que** la succession des impulsions de puissance (52) et des pauses d'impulsion (53) à haute fréquence correspond à une puissance moyenne à haute fréquence de 1 Watt à 100 Watt.

10. Procédé selon au moins l'une des revendications précédentes, **caractérisé en ce que** le cadençage (50, 51) à basse fréquence ou la modulation (50, 51) à basse fréquence s'effectuent à une fréquence de 50 Hz à 1 000 Hz.

11. Procédé selon au moins l'une des revendications précédentes, **caractérisé en ce que** le cadençage (50, 51) à basse fréquence ou la modulation (50, 51) à basse fréquence ont pour effet un débranchement et un branchement périodiques de la puissance pulsée à haute fréquence injectée.

12. Procédé selon au moins l'une des revendications précédentes, **caractérisé en ce que** la puissance moyenne injectée à haute fréquence dans le corps de gravure (18) est comprise entre 1 Watt et 30 Watt.

FIG.1a

50

51

51

50

50

FIG.1b

52

52

52

52

52

53

53

53

FIG.1c

54

FIG. 2

**FIG. 3a**

**FIG. 3b**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19706682 A1
- DE 4241045 C2
- DE 19933842
- DE 19919832
- JP 09232738 B
- JP 06342770 B